(19) Europäisches Patentamt / European Patent Office / Office européen des brevets

(11) EP 1 837 928 B1

(12) **EUROPEAN PATENT SPECIFICATION**

(45) Date of publication and mention of the grant of the patent:
**09.06.2010 Bulletin 2010/23**

(51) Int Cl.:
***H01L 51/00*** *(2006.01)*

(21) Application number: **07004110.8**

(22) Date of filing: **28.02.2007**

# (54) Organic semiconductor formulation

Organische Halbleiterformulierung

Formulation semi-conductrice organique

(84) Designated Contracting States:
**AT BE BG CH CY CZ DE DK EE ES FI FR GB GR HU IE IS IT LI LT LU LV MC NL PL PT RO SE SI SK TR**

(30) Priority: **24.03.2006 EP 06006093**

(43) Date of publication of application:
**26.09.2007 Bulletin 2007/39**

(73) Proprietor: **Merck Patent GmbH**
**64293 Darmstadt (DE)**

(72) Inventors:
- **Shkunov, Maxim**
  **Southampton SO16 6SX (GB)**
- **Simms, Richard**
  **Belfast BT16 1XD (GB)**
- **Heeney, Martin**
  **Southampton SO14 6TQ (GB)**
- **McColloch, Iain**
  **Chandlers Ford**
  **Southampton SO53 4LG (GB)**

(56) References cited:
**EP-A- 1 275 650**
**EP-A- 1 564 251**
**WO-A-03/050147**
**WO-A-2005/057677**
**US-A1- 2005 236 614**

- **SIRRINGHAUS H ET AL: "INTEGRATED, HIGH-MOBILITY POLYMER FIELD-EFFECT TRANSISTORS DRIVING POLYMER LIGHT-EMITTING DIODES" SYNTHETIC METALS, ELSEVIER SEQUOIA, LAUSANNE, CH, vol. 102, June 1999 (1999-06), pages 857-860, XP000934322 ISSN: 0379-6779**

EP 1 837 928 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

## Description

### Field of Invention

This invention relates to an improved organic semiconductor formulation comprising one or more surfactants, and to its use in electrically conducting, photoconducting and semiconducting components and devices.

### Background and Prior Art

Organic materials have shown promise as the active layers in organic field-effect transistors (OFETs), organic light emitting diodes (OLEDs) and organic photovoltaic devices (OPVs). OFETs are expected to find a wide use in smart cards, security tags and the switching elements in flat panel displays. Organic materials are envisaged to have substantial cost advantages over their silicon analogues if they can be deposited from solution, as this enables a fast, large-area fabrication route. Recent developments in high mobility OFETs indicate that hydrogenated amorphous silicon active matrix display drivers can be successfully replaced by their organic counterparts.

The performance of an OFET device is usually judged by: charge carrier mobility in the device, current On/Off ratio, position of threshold voltage, magnitude of the On and Off currents. The ability to achieve high transistor parameters in a solution deposition process (Roll-to-Roll, for example) with a minimum number of processing steps is considered to be a strong advantage.

Prior art reports that the charge mobility of a FET device can be improved by pre-treatment of the surface of the semiconductor substrate before applying the semiconductor material. This is achieved for example by applying a silylating agent like HMDS (hexamethyldisilazane) or OTS (octyl trichlorosilane) or evaporating a capping layer of $SiO_x$ onto the surface, resulting in highly hydrophobic surfaces. For example, H. Sirringhaus et al., Synthetic Metals 102, 857-860 (1999) and L. Burgi et al., Appl. Phys. Lett. 80, 2913-2915 (2002) report that OFET substrates treated with HMDS show an ~20 times increase in mobility compared to untreated substrates for regio-regular P3HT used as semiconductor. The substrate treatment was performed before organic semiconductor deposition. However, the extra step of substrate pre-treatment makes the production of FET devices more costly and time-consuming.

Therefore, there is still a need for organic semiconductor materials for use in OFET devices that have high charge carrier mobility, On current and On/Off ratio, good processability especially from solution and enable device preparation in an easy and time- and cost-effective way with a minimum number of processing steps.

It was an aim of the present invention to provide improved semiconductor materials having the above-mentioned properties and not having the disadvantages of the materials known from prior art. Other aims of the present invention are immediately evident to the person skilled in the art from the following detailed description.

It was found that these aims can be achieved by providing materials and methods as described the present invention. In particular, the inventors of the present invention found that by adding small amounts of surfactant to an organic semiconductor formulation it is possible to improve the charge mobility and On current of an OFET by up to ~10 times, and the On/Off ratio by ~5 times.

WO 03/050147 describes the preparation of nanoparticles and nanostructured layers of organic semiconductors by mixing an aqueous or alcoholic phase comprising a surfactant and an organic phase comprising one or more conjugated polymers in liquid form, producing a microemulsion or mini-emulsion, and optionally producing an aqueous dispersion, which is then coated on a substrate. However, phase-separated systems typically have abrupt boundaries that trap charge, have non-uniform phase distributions, exhibit anisotropic transport and are disadvantageous in charge transport devices.

US 2004/0144975 describes a coating composition having a low changing rate of the viscosity, and its use for preparing organic electroluminescent or semiconductor devices by an ink-jet printing method. The coating composition comprises a polar, glycol-based solvent such as diethylene glycol, monoethylene glycol or triethylene glycol, polythiophene derivatives as organic conductive material, and optionally an acetylene glycol surfactant. However, the use of polar solvents have limited use in practical semiconductor formulations as typically conjugated aromatic main-chain polymers are non-polar and thus are not compatible with polar solvents.

EP 1 564 251 A1 describes a coating composition comprising semiconducting polythiophenes, non-alcoholic solvents and a surface active additive.

### Summary of the Invention

The invention relates to a formulation, which is preferably a homogeneous solution, comprising one or more organic semiconducting compounds, one or more surface-active compounds as defined in claim 1, and one or more solvents selected from non-alcoholic organic solvents.

The invention further relates to a semiconductor layer obtainable by providing a formulation as described above

and below on a substrate and optionally removing the solvent.

The invention further relates to the use of a formulation or layer as described above and below as semiconducting, electrically conducting, photoconducting or light-emitting material in optical, electrooptical or electronic components or devices, organic field effect transistors (OFET), integrated circuitry (IC), thin film transistors (TFT), flat panel displays, radio frequency identification (RFID) tags, electroluminescent or photoluminescent devices or components, organic light emitting diodes (OLED), backlights of displays, organic photovoltaic devices (OPVs), sensor devices, charge injection layers, Schottky diodes, planarising layers, antistatic films, conducting substrates or patterns, electrode materials in batteries, photoconductors, electrophotographic applications, electrophotographic recording, organic memory devices, alignment layers, cosmetic or pharmaceutical compositions or for detecting and discriminating DNA sequences.

The invention further relates to a semiconducting, electrically conducting, photoconducting or light-emitting component or device, in particular an IC, OFET, TFT, OPV, RFID tag or OLED, characterized in that it comprises a formulation or layer as described above and below.

The invention further relates to a security marking or device, characterized in that it comprises an OFET or RFID tag as described above and below.

## Detailed Description of the Invention

The organic semiconductor formulation according to the present invention has improved performance in Field-Effect Transistor (FET) applications compared to single-component formulations. It is based on a solution of a semiconducting polymer in an organic solvent. The addition of a surfactant improves FET mobility, On current and On/Off ratio. This method of improving OFET characteristics can be applied for current commercially available semiconducting materials, like for example poly-3-hexylthiophene (P3HT), and novel compounds. The semiconducting materials can be polymeric, oligomeric or small-molecule compounds. Devices are not limited to OFETs but can also be other types that benefit from improved interfacial charge carrier mobility, like for example OPVs or sensors.

Preferred embodiments of the present invention relate to an organic semiconductor formulation characterized in that:

- the formulation is a homogeneous solution, which means that it is not phase-separated and is not e.g. a dispersion, emulsion, suspension, miniemulsion, microemulsion or micellar solution,
- the surfactants are monomeric or small-molecule compounds,
- the surfactants do not comprise an electron accepting group,
- the surfactants are selected from hydrophobic surfactants containing a head group capable of forming a covalent bond or a stable adsorption product with an active substrate, such as a chlorosilane or silazane group, and further comprising a tail group selected from alkyl, fluoroalkyl or siloxane groups,
- the surfactants are selected from silanes or silazanes,
- the concentration of the surfactants is from $10^{-5}$ to 5 %,
- the formulation comprises one or more organic semiconducting compounds selected from polymers,
- the semiconducting compounds are p-type organic semiconductors,
- the semiconducting compounds are selected from polymers or copolymers comprising one or more units selected from optionally substituted thiophene, optionally substituted selenophene, 3-alkylthiophene, optionally substituted [3,2-b]-thienothiophene, optionally substituted [2,3-b]-thienothiophene and optionally substituted dithienotiophene,
- the concentration of the organic semiconducting compounds is from 0.1 to 10 %,
- the organic solvents are selected from non-polar solvents, preferably having a polar contribution to the Hansen solubility parameter of < 6 Mpa $^{1/2}$ [for definition and measurement see "Hansen Solubility Parameters: A User's Handbook" by Charles M. Hansen; CRC Press 1999; ISBN 0 849 31525 5],
- the organic solvents are selected from non-alcoholic solvents,
- the organic solvents are selected from aliphatic and aromatic hydrocarbons, halogenated aliphatic and aromatic hydrocarbons,

Suitable non-polar solvents are for example xylene, toluene, benzene, tetralin, indane, xylene, dichlorobenzene, chloroform, dichloromethane, cyclohexane, anisole, N-methyl-2-pyrrolidone (NMP), dimethyl sulfoxide (DMSO), cyclohexanone, dioxane, tetrahydrofuran (THF), γ-butyrolactone or mixtures thereof.

Suitable surfactants are for example compounds comprising hydrocarbon, fluorocarbon, siloxane or silane groups. Especially preferred are monomeric or small-molecule surfactants. Further preferred are nonionic surfactants, in particular silanes like for example HMDS (1,1,1,3,3,3-Hexamethyldisilazane), OTS (octyl trichlorosilane) or ODTS (octadecyl trichloro silane), fluorocarbon silanes like 1H-,1H-,2H-,2H-perfluorooctyldimethylsilane or other silanes like optionally substituted trichlorosilane.

In principle all known semiconducting materials are suitable for use in the formulation according to the present

invention, including, but not limited to, polymers such as polyalkylthiophenes, polythiophenes, polyfluorenes, polyphenylamines and their copolymers, oligomers, and small molecules such as pentacene or other polyacenes, or other fused ring compounds.

Especially suitable and preferred materials are polymers with charge-carrying properties, very preferably with conjugated pi-systems, like for example polymers selected from polyphenylenevinylene (PPV), polyarylenevinylene (PAV), polyparaphenylene (PPP), polypyridine (PPy), polypyridinevinylene (PPyV), polythiophene (PT), polyalkylthiophene (PAT), polyfluorene (PF), polyspirobifluorene (PSF), polypyrrole, polyvinylcarbazole, polytriarylamine, polyacetylene, polyphenylene sulfide, polythienylene vinylene, polyisothianaphthene, polyazulene, polyfuran, polyaniline, polyselenophene, polyindenofluorene, all of which substituted or unsubstituted, or mixtures, blends, statistical or defined copolymers or block copolymers of the above.

Substituted polymers preferably comprise one or more identical or different substituents selected from $C_1$-$C_{40}$ alkyl groups, $C_2$-$C_{40}$ alkenyl groups, $C_2$-$C_{40}$ alkynyl groups, $C_3$-$C_{40}$ allyl groups, $C_4$-$C_{40}$ alkyldienyl groups, $C_4$-$C_{40}$ polyenyl groups, $C_6$-$C_{18}$ aryl groups, $C_6$-$C_{40}$ alkylaryl groups, $C_6$-$C_{40}$ arylalkyl groups, $C_4$-$C_{40}$ cycloalkyl groups, $C_4$-$C_{40}$ cycloalkenyl groups, very preferably having one of the meanings of $R^a$ as given below.

Especially preferred are polymers and copolymers comprising one or more units selected from optionally substituted thiophene, optionally substituted selenophene, 3-alkylthiophene, optionally substituted [3,2-b]-thienothiophene, optionally substituted [2,3-b]-thienothiophene and optionally substituted dithienotiophene, as disclosed for example in WO 2005/014691 A2, WO 2005/111045 A1, EP 1 279 689 A2, EP 1 279 691 A1, EP 1 284 276 A1, EP 1 398 336 A1, EP 1 411 563 A2, EP 1 439 590 A2, EP 1 477 504 A1 and EP 1 510 535 A1. Very preferred are polymers of the following formulae

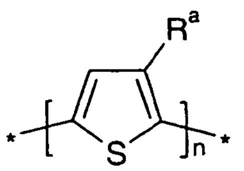

1

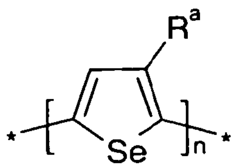

2

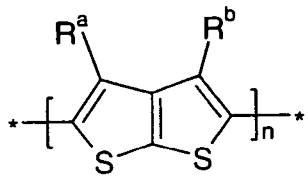

3

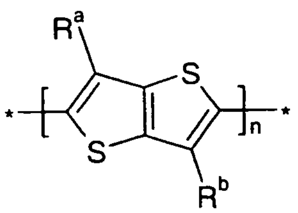

4

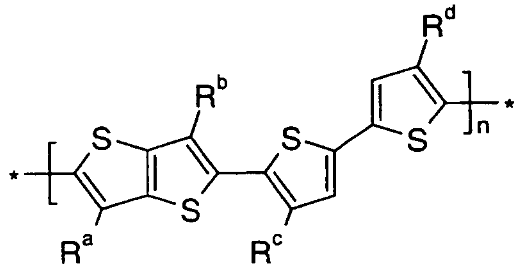

5

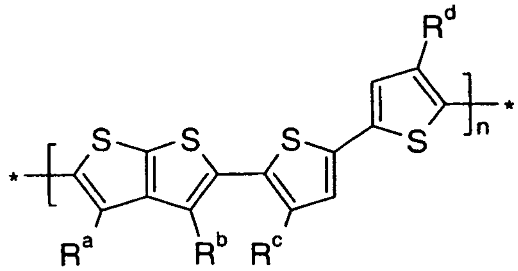

6

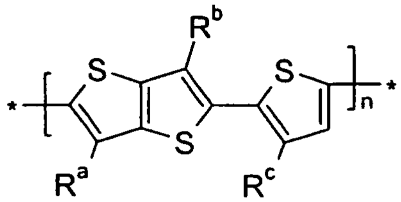

7

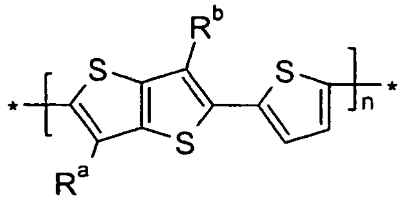

8

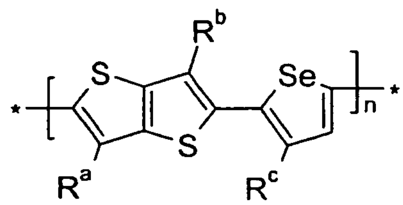

9

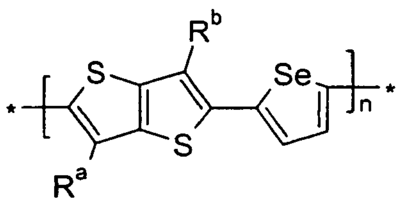

10

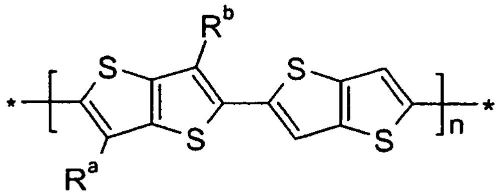

**11**

wherein

$R^a$, $R^b$, $R^c$, $R^d$ are independently of each other, and in case of multiple occurrence identical or different, selected from H, halogen, optionally substituted aryl or heteroaryl, or straight-hain, branched or cyclic alkyl with 1 to 20 C-atoms, which is optionally mono- or polysubstituted by F, Cl, Br, I or CN, and wherein one or more non-adjacent $CH_2$ groups are optionally replaced, in each case independently from one another, by- O-, -S-, -NH-, $-NR^0-$, $-SiR^0R^{00}-$, -CO-, -COO-, -OCO-, -O-CO-O-, -S-CO-, -CO-S-, $-CX^1=CX^2-$ or -C≡C- in such a manner that O and/or S atoms are not linked directly to one another,

$R^0$ and $R^{00}$ are independently of each other H, optionally substituted aryl or alkyl with 1 to 12 C-atoms,

$X^1$ and $X^2$ are independently of each other H, F, Cl or CN,

n is an integer > 1.

Very preferably $R^{a-d}$ are selected from $C_1$-$C_{20}$-alkyl that is optionally substituted with one or more fluorine atoms, $C_1$-$C_{20}$-alkenyl, $C_1$-$C_{20}$-alkynyl, $C_1$-$C_{20}$-alkoxy, $C_1$-$C_{20}$-thioalkyl, $C_1$-$C_{20}$-silyl, $C_1$-$C_{20}$-amino or $C_1$-$C_{20}$-fluoroalkyl, in particular from alkenyl, alkynyl, alkoxy, thioalkyl or fluoroalkyl, all of which are straight-chain and have 1 to 12, preferably 5 to 12 C-atoms, most preferably pentyl, hexyl, heptyl, octyl, nonyl, decyl, undecyl or dodecyl.

The formulation according to the present invention can additionally comprise one or more further components like for example lubricating agents, wetting agents, dispersing agents, hydrophobing agents, adhesive agents, flow improvers, defoaming agents, deaerators, diluents, reactive or non-reactive diluents, auxiliaries, colourants, dyes, pigments or nanoparticles, furthermore, especially in case crosslinkable binders are used, catalysts, sensitizers, stabilizers, inhibitors, chain-transfer agents or co-reacting monomers.

The formulation according to the present invention can be prepared by methods known in the art, for example by mixing one or more organic semiconducting compounds, one more surface-active compounds and one or more non-polar or non-alcoholic organic solvents as described above and below, or dissolving the compounds in the solvent(s).

The semiconductor formulations according to the present invention are useful as semiconducting, electrically conducting, photoconducting or light-emitting materials in optical, electrooptical or electronic components or devices, in particular in OFETs, OPVs or sensor devices, electrophotographic recording devices, and other semiconductor applications as described above and below. They are especially suitable for use in OFETs (e.g. for RFID tags or TFT applications) and OPVs, furthermore in components of OLED structures (like charge transport or emitting layers) for lighting or display applications.

The semiconductor formulation according to the present invention can also be used as an organic "metal" in applications including, but not limited to, charge injection layers and ITO planarising layers in organic light emitting diode applications, films for flat panel displays and touch screens, antistatic films, printed conductive substrates, patterns or tracts in electronic applications such as printed circuit boards and condensers.

OFETs where an organic semiconductive material is arranged as a film between a gate-dielectric and a drain and a source electrode, are generally known, for example from US 5,892,244, WO 00/79617, US 5,998,804 and from the references cited in the background and prior art section. Preferred applications of these FETs are for example integrated circuitry, TFT-displays and security applications.

In security applications, OFETs and other devices with semiconductive materials, like transistors or diodes, can be used for ID tags or security markings to authenticate and prevent counterfeiting of documents of value like banknotes, credit cards or ID cards, national ID documents, licenses or any product with money value, like stamps, tickets, shares, cheques and the like.

Alternatively, the semiconductors according to the invention can be used in OLEDs, for example in displays or as backlight of displays. Conventional OLEDs are typically realized by using multilayer structures. An emission layer is usually sandwiched between one or more electron-transport and/ or hole-transport layers. By applying an electric voltage electrons and holes as charge carriers move towards the emission layer where their recombination leads to the excitation

and hence luminescence of the lumophor units contained in the emission layer. The materials according to the present invention can be employed in one or more of the charge transport layers and/or in the emission layer, corresponding to their electrical and optical properties. The selection, characterization and processing of suitable monomeric, oligomeric and polymeric compounds or materials for the use in OLEDs is known to the ordinary expert and described for example in Meerholz, Synthetic Materials 111-112, 31-34 (2000) or Alcala, J. Appl. Phys. 88, 7124-7128 (2000) or the literature cited therein.

Semiconducting films or layers can be formed by providing a formulation according to the present invention onto a substrate and, if a solvent is present, removing the solvent. This can be done by well known techniques such as spin coating, dip coating, spray coating, brush coating or doctor blade coating, as well as printing techniques including but not limited to gravure printing, ink jet printing, stamping, screen printing, letter-press printing, roller printing, reverse-roller printing, offset lithography printing, flexographic printing, web printing, pad printing or other known printing methods.

Selected formulations of the present invention may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic semiconductor layer to a substrate. Additionally semi-industrial heads such as those manufactured by Brother, Epson, Konica, Seiko Instruments Toshiba TEC or single nozzle microdispensers such as those produced by Microdrop and Microfab may be used.

In order to be applied by ink jet printing or microdispensing, the mixture of the compound of formula I and the binder should be first dissolved in a suitable solvent. Solvents must fulfill the requirements stated above and must not have any detrimental effect on the chosen print head. Additionally, solvents should have boiling points >100°C, preferably >140°C and more preferably >150°C in order to prevent operability problems caused by the solution drying out inside the print head. Suitable solvents for printing include substituted and non-substituted xylene derivatives, di-$C_{1-2}$-alkyl formamide, substituted and non-substituted anisoles and other phenolether derivatives, substituted heterocycles such as substituted pyridines, pyrazines, pyrimidines, pyrrolidinones, substituted and non-substituted *N,N*-di-$C_{1-2}$-alkylanilines and other fluorinated or chlorinated aromatics.

Preferred formulations for ink jet printing comprise a benzene derivative which has a benzene ring substituted by one or more substituents wherein the total number of carbon atoms among the one or more substituents is at least three. For example, the benzene derivative may be substituted with a propyl group or three methyl groups, in either case there being at least three carbon atoms in total. Such a solvent enables an ink jet fluid to be formed comprising the solvent with the binder and the OSC compound which reduces or prevents clogging of the jets and separation of the components during spraying. The solvent(s) may include those selected from the following list of examples: dodecylbenzene, 1-methyl-4-tert-butylbenzene, terpineol limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer.

The ink jet fluid (that is mixture of solvent, surfactant and semiconducting compound) preferably has a viscosity at 20°C of 1-100mPa·s, more preferably 1-50mPa·s and most preferably 1-30mPa·s.

The semiconducting layer in a device according to the present invention is typically at most 1 micron (=1μm) thick, although it may be thicker if required. The exact thickness of the layer will depend, for example, upon the requirements of the electronic device in which the layer is used. For use in an OFET or OLED, the layer thickness may typically be 500 nm or less.

The substrate used for preparing an OSC layer may include any underlying device layer, electrode or separate substrate such as silicon wafer, glass or polymer substrate for example.

An OFET device according to the present invention preferably comprises:

- a source electrode,
- a drain electrode,
- a gate electrode,
- an OSC layer as described above,
- one or more gate insulator layers,
- optionally a substrate,

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

The OFET device can be a top gate device or a bottom gate device. Suitable structures and manufacturing methods of an OFET device are known to the skilled in the art and are described in the literature, for example in WO

03/052841.

The gate insulator layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont) or Fluoropel® (from Cytonix) or the perfluorosolvent FC 43® (Acros, No. 12377).

Throughout the description and claims of this specification, unless the context clearly indicates otherwise, as used herein plural forms of the terms herein are to be construed as including the singular form and vice versa. The words "comprise" and "contain" and variations of the words, for example "comprising" and "comprises", mean "including but not limited to", and are not intended to (and do not) exclude other components.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

The invention will now be described in more detail by reference to the following examples, which are illustrative only and do not limit the scope of the invention.

Unless stated otherwise, in the foregoing and the following, all temperatures are given in degrees Celsius, and all percentages are by weight. All specific values of physical parameters like the permittivity ($\varepsilon$), charge carrier mobility ($\mu$), solubility parameter ($\delta$) and viscosity ($\eta$) as given above and below refer to a temperature of 20°C (+/- 1°C). Ratios of monomers or repeating units in polymers are given in mol %. Ratios of polymers in polymer blends are given in weight %. The molecular weight of polymers is given as weight average molecular weight $M_w$ (GPC, polystyrene standard).

The Hansen parameter is determined as described in "Hansen Solubility Parameters: A User's Handbook' by Charles M. Hansen; CRC Press 1999; ISBN 0 849 315255.

Formulation viscosities are obtained using an automated microviscometer (available for example from Anton Paar GmbH, Graz, Austria), which is based on the rolling/falling ball principle. A capillary is used in which a small metal ball rolls and by tilting this one way or the other the ball will descent through the liquid and can be timed. The length of time taken to pass a set distance through the liquid is proportional to the viscosity and the angle at which the tube is held at during this determines the shear rate of the measurement - which, for a Newtonian liquid, should not affect the recorded viscosity.

Example 1

A polymer based FET is prepared from a formulation containing the following semiconducting polymer P1 from 0.2 to 10% and 0.01 % of silane (OTS) in xylene as organic solvent.

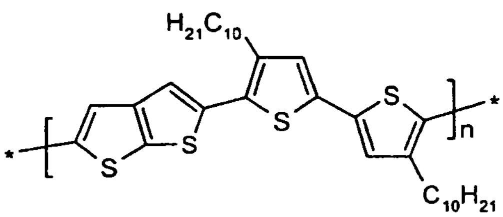

P1

The synthesis of P1 is described in EP 1 510 535 A1.

The warm formulation is deposited onto an ozone-cleaned (hydrophilic) Si/$SiO_2$ FET substrate with pre-defined gold source-drain electrodes and common Si-gate. After ~15min the substrate is spun, resulting in a formation of a thin film of polymer P1 on the FET substrate. A control sample is prepared from the pristine P1-polymer solution in xylene

following the same procedure as the above sample. The electrical characterization of the transistor devices was carried out in dry nitrogen atmosphere using computer controlled Agilent 4155C Semiconductor Parameter Analyser. Field-effect mobility was calculated in saturation regime, where drain current is expressed as:

$$I_d^{sat} = \frac{WC_i}{2L}\mu^{sat}(V_g - V_{th})^2 \qquad (1)$$

where W is the channel width, L the channel length, $C_i$ the capacitance of insulating layer, Vg the gate voltage, $V_{th}$ the threshold voltage.

$V_{th}$ is estimated from linear fit of $\sqrt{I_d^{sat}}$ **vs. $V_g$,** vs. Vg, and mobility is extracted from the slope of the linear fit according to formula (1). The results are summarised in Table 1 below.

Table 1 - Electrical properties of OFETs fabricated from pristine polymer solution and from formulation containing OTS

| On/Off ratio | | FET On Current (A); Saturated regime | | FET Mobility ($cm^2/Vs$); Saturated regime | |
|---|---|---|---|---|---|
| Pristine | With OTS | Pristine | With OTS | Pristine | With OTS |
| $2\times10^4$ | $9\times10^4$ | $7.2\times10^{-6}$ | $6.0\times10^{-5}$ | $5.2\times10^4$ | $4.7\times10^{-3}$ |

As can be seen from table 1, the use of a formulation according to the invention comprising the surfactant OTS increases the FET On Current and FET Mobility at ~10 times, compared to the pristine solution without OTS.

## Claims

1. Formulation comprising one or more organic semiconducting compounds, one more surface-active compounds and one or more solvents selected from the group of non-alcoholic organic solvents, **characterized in that** the surface-active compounds are selected from the group consisting of hydrophobic surfactants containing a head group selected from chlorosilane or silazane groups, and further comprising a tail group selected from alkyl, fluoroalkyl or siloxane groups.

2. Formulation according to claim 1, **characterized in that** the surface-active compounds are selected from the group of HMDS (1,1,1,3,3,3-Hexamethyldisilazane), OTS (octyl trichlorosilane), ODTS (octadecyl trichloro silane) and optionally substituted trichlorosilanes.

3. Formulation according to one or more of claims 1 or 2, **characterized in that** the concentration of the surface-active compounds is from $10^{-5}$ to 5 wt. %.

4. Formulation according to one or more of claims 1 to 3, **characterized in that** the organic semiconducting compounds are selected from the group consisting of polymeric, oligomeric and small-molecule compounds.

5. Formulation according to one or more of claims 1 to 4, **characterized in that** the organic semiconducting compounds are p-type organic semiconductors.

6. Formulation according to one or more of claims 1 to 5, **characterized in that** the organic semiconducting compounds are selected from polymers with conjugated pi-systems.

7. Formulation according to one or more of claims 1 to 6, **characterized in that** the organic semiconducting compounds are selected from polyphenylenevinylene (PPV), polyarylenevinylene (PAV), polyparaphenylene (PPP), polypyridine (PPy), polypyridinevinylene (PPyV), polythiophene (PT), polyalkylthiophene (PAT), polyfluorene (PF), polyspirobifluorene (PSF), polypyrrole, polyvinylcarbazole, polytriarylamine, polyacetylene, polyphenylene sulfide, polythienylene vinylene, polyisothianaphthene, polyazulene, polyfuran, polyaniline, polyselenophene, polyindenofluorene, all of which are substituted or unsubstituted, or mixtures, blends, statistical or defined copolymers or block copolymers of the above.

**8.** Formulation according to one or more of claims 1 to 7, **characterized in that** the organic semiconducting compounds are selected from polymers or copolymers comprising one or more units selected from optionally substituted thiophene, optionally substituted selenophene, 3-alkylthiophene, optionally substituted [3,2b]-thienothiophene, optionally substituted [2,3b]-thienothiophene and optionally substituted dithienotiophene.

**9.** Formulation according to one or more of claims 1 to 8, **characterized in that** the organic semiconducting compounds are selected from the following formulae

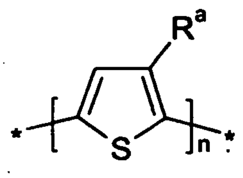

1

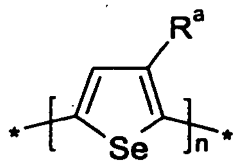

2

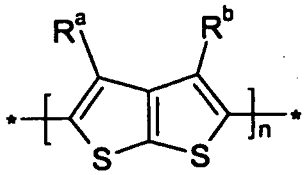

3

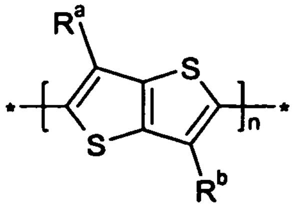

4

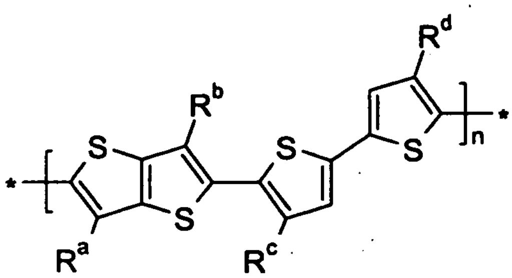

5

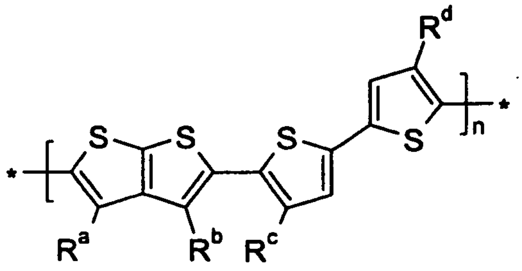

6

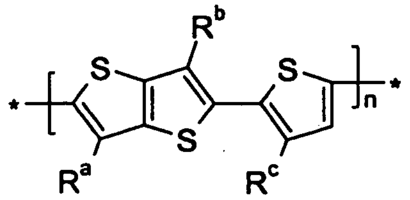

7

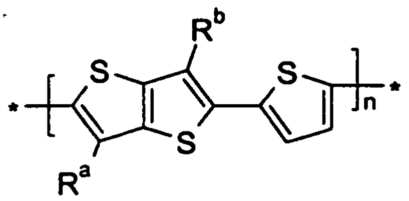

8

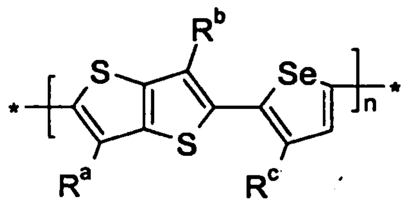

9

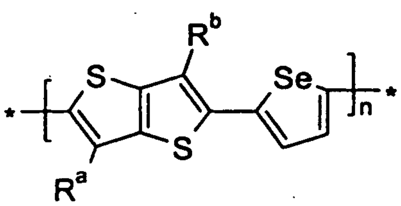

10

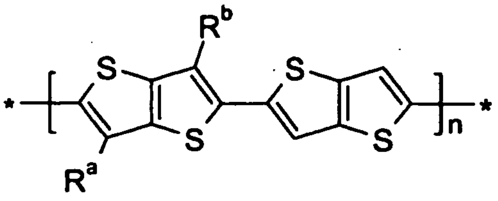

11

wherein

$R^a$, $R^b$, $R^c$, $R^d$ are independently of each other, and in case of multiple occurrence identical or different, selected from H, halogen, optionally substituted aryl or heteroaryl, or straight-hain, branched or cyclic alkyl with 1 to 20 C-atoms, which is optionally mono- or polysubstituted by F, Cl, Br, I or CN, and wherein one or more non-adjacent $CH_2$ groups are optionally replaced, in each case independently from one another, by -O-, -S-, -NH-, $-NR^0-$, $-SiR^0R^{00}-$, -CO-, - COO-, -OCO-, -O-CO-O-, -S-CO-, -CO-S-, $-CX^1=CX^2-$ or -C≡C- in such a manner that O and/or S atoms are not linked directly to one another,
$R^0$ and $R^{00}$ are independently of each other H, optionally substituted aryl or alkyl with 1 to 12 C-atoms,
$X^1$ and $X^2$ are independently of each other H, F, Cl or CN,
n is an integer ≥ 1.

**10.** Formulation according to one or more of claims 1 to 9, **characterized in that** the concentration of the organic semiconducting compounds is from 0.1 to 10 %.

**11.** Formulation according to one or more of claims 1 to 10, **characterized in that** the solvents are selected from solvents having a polar contribution to the Hansen solubility parameter of < 6 Mpa $^{1/2}$.

**12.** Formulation according to one or more of claims 1 to 11, **characterized in that** the organic solvents are selected from non-alcoholic aliphatic and aromatic hydrocarbons, halogenated aliphatic and aromatic hydrocarbons.

**13.** Formulation according to one or more of claims 1 to 12, **characterized in that** the organic solvents are selected from xylene, toluene, benzene, tetralin, indane, xylene, dichlorobenzene, chloroform, dichloromethane, cyclohexane, anisole, N-methyl-2-pyrrolidone (NMP), dimethyl sulfoxide (DMSO), cyclohexanone, dioxane, tetrahydrofuran (THF), γ-butyrolactone or mixtures thereof.

**14.** Process of preparing an organic semiconductor layer by providing a formulation according to one or more of claims 1 to 13 onto a substrate and optionally removing the solvent.

**15.** Use of a formulation or process according to one or more of claims 1 to 14 in semiconducting, electrically conducting, photoconducting or light-emitting material in optical, electrooptical or electronic components or devices, organic field effect transistors (OFET), integrated circuitry (IC), thin film transistors (TFT), flat panel displays, radio frequency identification (RFID) tags, electroluminescent or photoluminescent devices or components, organic light emitting diodes (OLED), backlights of displays, organic photovoltaic devices (OPVs), sensor devices, charge injection layers, Schottky diodes, planarising layers, antistatic films, conducting substrates or patterns, electrode materials in batteries, photoconductors, electrophotographic applications, electrophotographic recording, organic memory devices, alignment layers, cosmetic or pharmaceutical compositions or for detecting and discriminating DNA sequences.

**16.** Semiconducting, electrically conducting, photoconducting or light-emitting component or device, **characterized in that** it comprises a formulation according to one or more of claims 1 to 13.

**17.** Component or device according to claim 16, **characterized in that** it is an IC, OFET, TFT, OPV, RFID tag or OLED.

**18.** Security marking or device, **characterized in that** it comprises an OFET or RFID tag according to claim 17.

**19.** Method of preparing a formulation according to one or more of claims 1 to 13, by mixing one or more organic semiconducting compounds, one more surface-active compounds and one or more non-alcoholic organic solvents as defined in one or more of claims 1 to 13.

**Patentansprüche**

**1.** Formulierung enthaltend eine oder mehrere organische Halbleiterverbindungen, eine oder mehrere oberflächenaktive Verbindungen und ein oder mehrere Lösungsmittel ausgewählt aus der Gruppe der nichtalkoholischen organischen Lösungsmittel, **dadurch gekennzeichnet, dass** die oberflächenaktiven Verbindungen aus der Gruppe bestehend aus hydrophoben Tensiden enthaltend eine Kopfgruppe ausgewählt aus Chlorsilan- oder Silazangruppen und weiterhin enthaltend eine Schwanzgruppe ausgewählt aus Alkyl-, Fluoralkyl- oder Siloxangruppen ausgewählt sind.

**2.** Formulierung nach Anspruch 1, **dadurch gekennzeichnet, dass** die oberflächenaktiven Verbindungen aus der

Gruppe von HMDS (1,1,1,3,3,3-Hexamethyldisilazan), OTS (Octyltrichlorsilan), ODTS (Octadecyltrichlorsilan) und gegebenenfalls substituierten Trichlorsilanen ausgewählt sind.

3. Formulierung nach einem oder mehreren der Ansprüche 1 oder 2, **dadurch gekennzeichnet, dass** die Konzentration der oberflächenaktiven Verbindungen $10^{-5}$ bis 5 Gew.-% beträgt.

4. Formulierung nach einem oder mehreren der Ansprüche 1 bis 3, **dadurch gekennzeichnet, dass** die organischen Halbleiterverbindungen aus der Gruppe bestehend aus polymeren, oligomeren und Kleinmolekül-Verbindungen ausgewählt sind.

5. Formulierung nach einem oder mehreren der Ansprüche 1 bis 4, **dadurch gekennzeichnet, dass** die organischen Halbleiterverbindungen organische Halbleiter des p-Typs sind.

6. Formulierung nach einem oder mehreren der Ansprüche 1 bis 5, **dadurch gekennzeichnet, dass** die organischen Halbleiterverbindungen aus Polymeren mit konjugierten Pi-Systemen ausgewählt sind.

7. Formulierung nach einem oder mehreren der Ansprüche 1 bis 6, **dadurch gekennzeichnet, dass** die organischen Halbleiterverbindungen aus Polyphenylenvinylen (PPV), Polyarylenvinylen (PAV), Polyparaphenylen (PPP), Polypyridin (PPy), Polypyridinvinylen (PPyV), Polythiophen (PT), Polyalkylthiophen (PAT), Polyfluoren (PF), Polyspirobifluoren (PSF), Polypyrrol, Polyvinylcarbazol, Polytriarylamin, Polyacetylen, Polyphenylensulfid, Polythienylenvinylen, Polyisothianaphthen, Polyazulen, Polyfuran, Polyanilin, Polyselenophen, Polyindenofluoren, die alle jeweils substituiert oder unsubstituiert sind, oder deren Mischungen, Blends, statistischen oder definierten Copolymeren oder Blockcopolymeren ausgewählt sind.

8. Formulierung nach einem oder mehreren der Ansprüche 1 bis 7, **dadurch gekennzeichnet, dass** die organischen Halbleiterverbindungen aus Polymeren oder Copolymeren ausgewählt sind, die eine oder mehrere Einheiten ausgewählt aus gegebenenfalls substituiertem Thiophen, gegebenenfalls substituiertem Selenophen, 3-Alkylthiophen, gegebenenfalls substituiertem [3,2b]-Thienothiophen, gegebenenfalls substituiertem [2,3b]-Thienothiophen und gegebenenfalls substituiertem Dithienotiophen enthalten.

9. Formulierung nach einem oder mehreren der Ansprüche 1 bis 8, **dadurch gekennzeichnet, dass** die organischen Halbleiterverbindungen aus den folgenden Formeln ausgewählt sind:

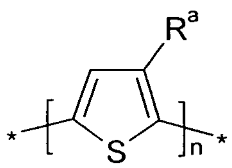

1

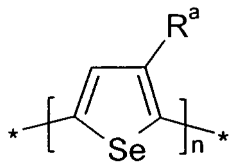

2

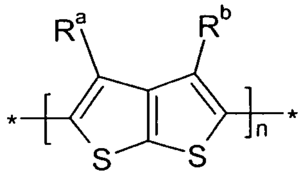

3

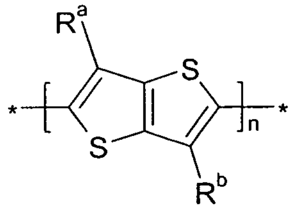

4

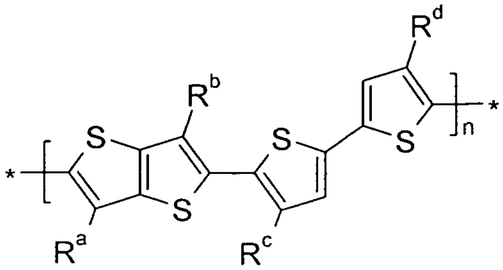

5

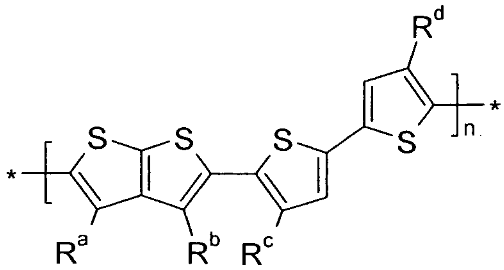

6

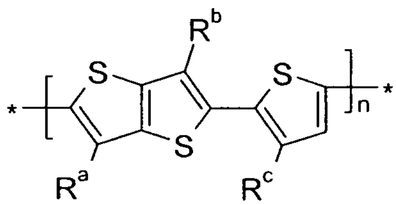

7

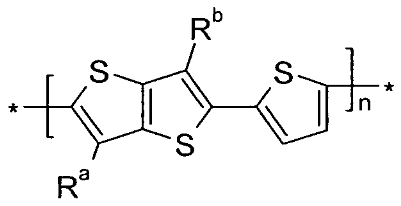

8

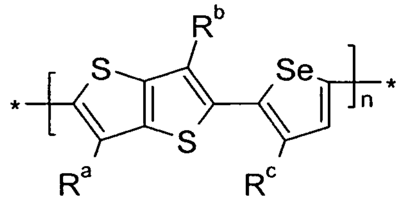

9

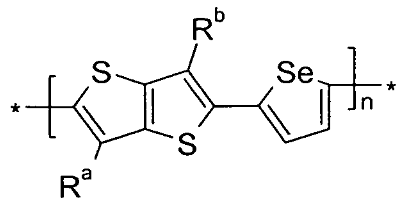

10

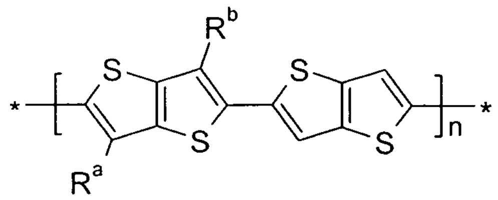

11

worin

$R^a$, $R^b$ $R^c$, $R^d$ unabhängig voneinander und bei mehrfachem Auftreten gleich oder verschieden aus H, Halogen, gegebenenfalls substituiertem Aryl oder Heteroaryl oder geradkettigem, verzweigtem oder cyclischem Alkyl mit 1 bis 20 C-Atomen ausgewählt sind, welches gegebenenfalls ein- oder mehr- fach durch F, Cl, Br, I oder CN substituiert ist und worin eine oder mehrere nicht benachbarte $CH_2$-Gruppen gege- benenfalls jeweils unabhängig voneinander so durch -O-, -S-, -NH-, $-NR^0-$, $-SiR^0R^{00}-$, -CO-, -COO-, -OCO-, -O-CO- O-, -S-CO-, -CO-S-, $-CX^1=CX^2-$ oder -C≡C- ersetzt sind, dass O- und/oder S-Atome nicht direkt miteinander ver- knüpft sind,
$R^0$ und $R^{00}$ unabhängig voneinander H, gegebenenfalls substituiertes Aryl oder Alkyl mit 1 bis 12 C-Atomen bedeuten,
$X^1$ und $X^2$ unabhängig voneinander H, F, Cl oder CN bedeuten,
n für eine ganze Zahl ≥ 1 steht.

**10.** Formulierung nach einem oder mehreren der Ansprüche 1 bis 9, **dadurch gekennzeichnet, dass** die Konzentration der organischen Halbleiterverbindungen 0,1 bis 10 % beträgt.

**11.** Formulierung nach einem oder mehreren der Ansprüche 1 bis 10, **dadurch gekennzeichnet, dass** die Lösungsmittel aus Lösungsmitteln mit einem polaren Beitrag zum Hansen-Löslichkeitsparameter von < 6 Pa $^{1/2}$ ausgewählt sind.

12. Formulierung nach einem oder mehreren der Ansprüche 1 bis 11, **dadurch gekennzeichnet, dass** die organischen Lösungsmittel aus nichtalkoholischen aliphatischen und aromatischen Kohlenwasserstoffen, halogenierten aliphatischen und aromatischen Kohlenwasserstoffen ausgewählt sind.

13. Formulierung nach einem oder mehreren der Ansprüche 1 bis 12, **dadurch gekennzeichnet, dass** die organischen Lösungsmittel aus Xylol, Toluol, Benzol, Tetralin, Indan, Dichlorbenzol, Chloroform, Dichlormethan, Cyclohexan, Anisol, N-Methyl-2-pyrrolidon (NMP), Dimethylsulfoxid (DMSO), Cyclohexanon, Dioxan, Tetrahydrofuran (THF), γ-Butyrolacton oder deren Mischungen ausgewählt sind.

14. Verfahren zur Herstellung einer organischen Halbleiterschicht, bei dem man eine Formulierung nach einem oder mehreren der Ansprüche 1 bis 13 auf einem Substrat bereitstellt und gegebenenfalls das Lösungsmittel entfernt.

15. Verwendung einer Formulierung oder eines Verfahrens nach einem oder mehreren der Ansprüche 1 bis 14 in halbleitendem, elektrisch leitendem, photoleitendem oder lichtemittierendem Material in optischen, elektrooptischen oder elektronischen Komponenten oder Vorrichtungen, organischen Feldeffekttransistoren (organic field effect transistors - OFET), integrierten Schaltungen (integrated circuitry - IC), Dünnfilmtransistoren (thin film transistors - TFT), Flachbildschirmen, RFID-Tags (RFID - radio frequency identification), Elektrolumineszenz- oder Photolumineszenzvorrichtungen oder -komponenten, organischen Leuchtdioden (organic light emitting diodes - OLED), Hintergrundbeleuchtungen von Displays, organischen photovoltaischen Vorrichtungen (organic photovoltaic devices - OPVs), Sensorvorrichtungen, Ladungsinjektionsschichten, Schottky-Dioden, Planarisierungsschichten, Antistatikfolien, leitenden Substraten oder Strukturen, Elektrodenmaterialien in Batterien, Photoleitern, elektrophotographischen Anwendungen, elektrophotographischer Aufzeichnung, organischen Speichervorrichtungen, Orientierungsschichten, kosmetischen oder pharmazeutischen Zusammensetzungen oder für den Nachweis und die Unterscheidung von DNA-Sequenzen.

16. Halbleitende, elektrisch leitende, photoleitende oder lichtemittierende Komponente oder Vorrichtung, **dadurch gekennzeichnet, dass** sie eine Formulierung nach einem oder mehreren der Ansprüche 1 bis 13 enthält.

17. Komponente oder Vorrichtung nach Anspruch 16, **dadurch gekennzeichnet, dass** es sich um eine IC, einen OFET, einen TFT, eine OPV, ein RFID-Tag oder eine OLED handelt.

18. Sicherheitsmarkierung oder -vorrichtung, **dadurch gekennzeichnet, dass** sie einen OFET oder ein RFID-Tag nach Anspruch 17 enthält.

19. Verfahren zur Herstellung einer Formulierung nach einem oder mehreren der Ansprüche 1 bis 13, bei dem man eine oder mehrere organische Halbleiterverbindungen, eine oder mehrere oberflächenaktive Verbindungen und ein oder mehrere nichtalkoholische organische Lösungsmittel wie in einem oder mehreren der Ansprüche 1 bis 13 definiert mischt.

## Revendications

1. Formulation comprenant un ou plusieurs composés semiconducteurs organiques, un ou plusieurs composés tensioactifs et un ou plusieurs solvants choisis parmi le groupe des solvants organiques non alcooliques, **caractérisée en ce que** les composés tensioactifs sont choisis parmi le groupe constitué des surfactants hydrophobes contenant un groupe de tête choisi parmi les groupes chlorosillane ou silazane, et comprenant en outre un groupe de queue choisi parmi les groupes alkyle,fluoroalkyle ou siloxane.

2. Formulation selon la revendication 1, **caractérisée en ce que** les composés tensioactifs sont choisis parmi le groupe de HMDS (1,1,1,3,3,3-hexaméthyldisilazane), OTS (octyle trichlorosilane), ODTS (octadécyle trichlorosilane), et trichlorosilanes optionnellement substitués.

3. Formulation selon une ou plusieurs des revendications 1 ou 2, **caractérisée en ce que** la concentration des composés tensioactifs est de $10^{-5}$ à 5 % en poids.

4. Formulation selon une ou plusieurs des revendications 1 à 3, **caractérisée en ce que** les composés semiconducteurs organiques sont choisis parmi le groupe constitué des composés polymériques, oligomériques et à petite molécule.

5. Formulation selon une ou plusieurs des revendications 1 à 4, **caractérisée en ce que** les composés semiconducteurs organiques sont des semiconducteurs organiques de type p.

6. Formulation selon une ou plusieurs des revendications 1 à 5, **caractérisée en ce que** les composés semiconducteurs organiques sont choisis parmi les polymères avec des systèmes pi conjugués.

7. Formulation selon une ou plusieurs des revendications 1 à 6, **caractérisée en ce que** les composés semiconducteurs organiques sont choisis parmi polyphénylènevinylène (PPV), polyarylènevinylène (PAV), polyparaphénylène (PPP), polypyridine (PPy), polypyridinevinylène (PPyV), polythiophène (PT), polyalkylthiophène (PAT), polyfluorène (PF), polyspirobifluorène (PSF), polypyrrole, polyvinylcarbazole, polytriarylamine, polyacétylène, sulfure de polyphénylène, vinylène de polythienylene, polyisothianaphthène, polyazulène, polyfurane, polyaniline, polysélénophène, polyindénofluorène, tous ceux-ci sont substitués ou non substitués, ou des copolymères ou copolymères bloc en mélanges, associations, statistiques ou définis des composés ci-dessus.

8. Formulation selon une ou plusieurs des revendications 1 à 7, **caractérisée en ce que** les composés semiconducteurs organiques sont choisis parmi les polymères ou copolymères comprenant une ou plusieurs unités choisies parmi thiophène optionnellement substitué, sélénophène optionnellement substitué, 3-alkylthiophène, [3,2b]-thiénothiophène optionnellement substitué, [2,3b]-thiénothiophène optionnellement substitué et dithiénotiophène optionnellement substitué.

9. Formulation selon une ou plusieurs des revendications 1 à 8, **caractérisée en ce que** les composés semiconducteurs organiques sont choisis parmi les formules suivantes

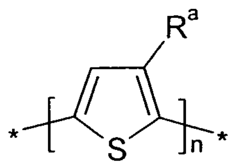

1

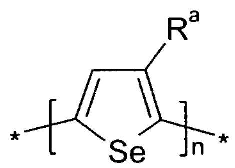

2

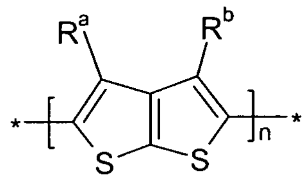

3

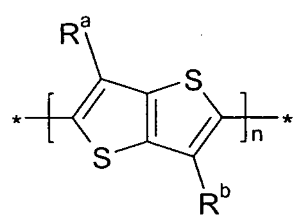

4

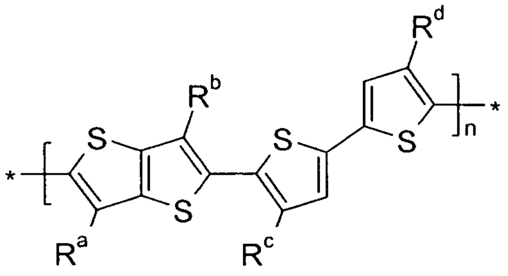

5

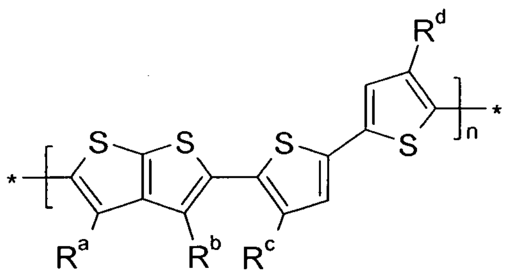

6

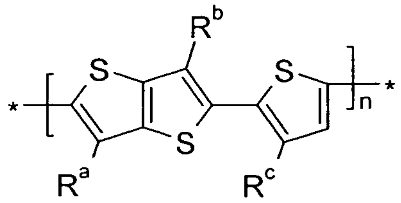

7

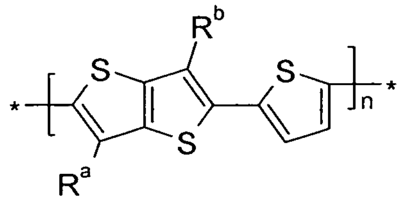

8

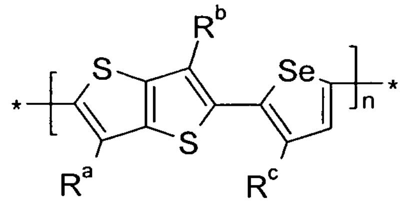

9

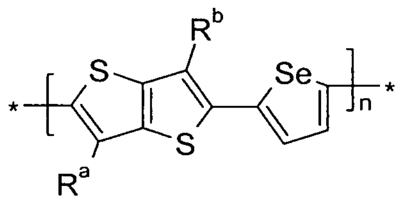

10

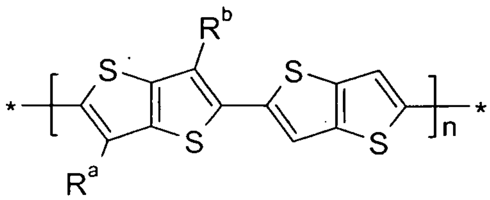

11

dans lesquelles

$R^a$, $R^b$ $R^c$, $R^d$ sont indépendamment l'un de l'autre, et dans le cas de multiples occurrences de façon identique ou diffé- rente, choisis parmi H, halogène, aryle ou hétéroaryle optionnellement substitué, ou alkyle en chaîne droite, ramifié ou cyclique avec 1 à 20 atomes de C, qui est optionnellement mono- ou polysubstitué par F, Cl, Br, I ou CN, et dans lequel un ou plusieurs groupes $CH_2$ non adjacents sont optionnellement remplacés, dans chaque cas indépendamment l'un de l'autre, par -O-, -S-, -NH-, $-NR^0-$, $-SiR^0R^{00}-$, -CO-, -COO-, -OCO-, -O-CO-O-, -S-CO-, -CO-S-, $-CX^1=CX^2-$ ou -C≡C- de telle sorte que des atomes de O et/ou S ne soient pas liés directement l'un à l'autre,
$R^0$ et $R^{00}$ sont indépendamment l'un de l'autre H, aryle ou alkyle optionnellement substitué avec 1 à 12 atomes de C,
$X^1$ et $X^2$ sont indépendamment l'un de l'autre H, F, Cl ou CN,
n est un entier ≥ 1.

**10.** Formulation selon une ou plusieurs des revendications 1 à 9, **caractérisée en ce que** la concentration des composés semiconducteurs organiques est de 0.1 à 10 %.

**11.** Formulation selon une ou plusieurs des revendications 1 à 10, **caractérisée en ce que** les solvants sont choisis parmi les solvants ayant une contribution polaire au paramètre de solubilité de Hansen de < 6 Mpa $^{1/2}$.

**12.** Formulation selon une ou plusieurs des revendications 1 à 11, **caractérisée en ce que** les solvants organiques sont choisis parmi hydrocarbures aliphatiques et aromatiques non alcooliques, hydrocarbures aliphatiques et aromatiques halogénés.

**13.** Formulation selon une ou plusieurs des revendications 1 à 12, **caractérisée en ce que** les solvants organiques sont choisis parmi xylène, toluène, benzène, tétraline, indane, xylène, dichlorobenzène, chloroforme, dichlorométhane, cyclohexane, anisole, N-méthyl-2-pyrrolidone (NMP), diméthyle sulfoxyde (DMSO), cyclohexanone, dioxane, tétrahydrofurane (THF), γ-butyrolactone ou des mélanges de ceux-ci.

**14.** Procédé de préparation d'une couche semiconductrice organique en constituant une formulation selon une ou plusieurs des revendications 1 à 13 sur un substrat et optionnellement en enlevant le solvant.

**15.** Utilisation d'une formulation ou d'un procédé selon une ou plusieurs des revendications 1 à 14 en semiconduction, conduction électrique, matériau de photoconduction ou d'émission de lumière dans des composants ou dispositifs électriques, électrooptiques ou électroniques, transistors à effet de champ organiques (OFET), circuits intégrés (IC), transistors à film mince (TFT), affichages à écran plat, étiquettes d'identification radio fréquence (RFID), dispositifs ou composants électroluminescents ou photoluminescents, diodes émettrices de lumière organiques (OLED), éclairages arrière d'affichages, dispositifs photovoltaïques organiques (OPVs), dispositifs de capteurs, couches d'injection de charges, diodes Schottky, couches de planarisation, films antistatiques, substrats ou motifs de conduction,

matériaux d'électrodes dans des batteries, photoconducteurs, applications électrophotographiques, enregistrement électrophotographique, dispositifs de mémoire organique, couches d'alignement, compositions cosmétiques ou pharmaceutiques ou pour détecter ou discriminer des séquences ADN.

**16.** Composant ou dispositif de semiconduction, conduction électrique, photoconduction ou émission de lumière, **caractérisé en ce qu'**il comprend une formulation selon une ou plusieurs des revendications 1 à 13.

**17.** Composant ou dispositif selon la revendication 16, **caractérisé en ce qu'**il est un IC, OFET, TFT, OPV, une étiquette RFID ou une OLED.

**18.** Marquage ou dispositif de sécurité, **caractérisé en ce qu'**il comprend un OFET ou une étiquette RFID selon la revendication 17.

**19.** Procédé de préparation d'une formulation selon une ou plusieurs des revendications 1 à 13, en mélangeant un ou plusieurs composés semiconducteurs organiques, un ou plusieurs composants tensioactifs et un ou plusieurs solvants non alcooliques comme définis dans une ou plusieurs des revendications 1 à 13.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 03050147 A
- US 20040144975 A
- EP 1564251 A1
- WO 2005014691 A2
- WO 2005111045 A1
- EP 1279689 A2
- EP 1279691 A1
- EP 1284276 A1
- EP 1398336 A1
- EP 1411563 A2
- EP 1439590 A2
- EP 1477504 A1
- EP 1510535 A1
- US 5892244 A
- WO 0079617 A
- US 5998804 A
- WO 03052841 A


### Non-patent literature cited in the description


- **H. SIRRINGHAUS et al.** *Synthetic Metals,* 1999, vol. 102, 857-860
- **L. BURGI et al.** *Appl. Phys. Lett.,* 2002, vol. 80, 2913-2915
- **CHARLES M. HANSEN.** Hansen Solubility Parameters: A User's Handbook. CRC Press, 1999
- **MEERHOLZ.** *Synthetic Materials,* 2000, vol. 111-112, 31-34
- **ALCALA.** *J. Appl. Phys.,* 2000, vol. 88, 7124-7128